# EUROPEAN PATENT SPECIFICATION

(11) **EP 2 811 507 B1**
(45) Date of publication and mention of the grant of the patent: **19.02.2020**
(21) Application number: 13171155.8
(22) Date of filing: 07.06.2013
(51) Int. Cl.: H01J 37/32, H01J 37/34

(54) **Magnetic configuration for a magnetron sputter deposition system**
Magnetische Konfiguration für ein Magnetron-Sputterauftragungssystem
Configuration magnétique pour un système de dépôt par pulvérisation de magnétron

(43) Date of publication of application: 10.12.2014
(73) Proprietor: Soleras Advanced Coatings bvba, 9800 Deinze (BE)
(72) Inventor: De Bosscher, Wilmert, 9031 Drongen (BE)
(74) Representative: Wauters, Davy Erik Angelo

(56) References cited:
- WO-A1-91/14797
- DE-A1- 4 202 211
- GB-A- 2 340 845
- US-A1- 2003 155 236
- US-A1- 2010 181 191
- US-B1- 6 488 824

## Description

### Field of the invention

The invention relates to the field of magnetron sputter deposition. More specifically it relates to a magnetron sputter deposition system comprising multiple magnetron sputter units and the magnetic configuration thereof.

### Background of the invention

Sputter deposition has become a widespread technique to add functionalities to substrates such as film, sheet form materials or more complex shaped 3-dimensional objects. In a low-pressure sputter deposition coater, ionized gas ions are accelerated towards a negatively biased target. Atoms are kicked out of the target when the gas ions impinge on its surface. A magnet system may be provided under the target surface to confine the free electrons in a racetrack. Within the racetrack the ionization degree of the gas is greatly increased and the ion bombardment of the target is therefore more intense below the racetrack. Hence the magnet system defines the area on the target from which atoms are sputtered away. Moreover, under the racetrack, target atoms are ejected mainly in a direction according to a Lambertian distribution perpendicular to the surface of the target. Such a process is known as magnetron sputter deposition. The knocked-out atoms hit the substrate surface where a dense coating forms. When also reactive gasses are admitted into the coater, reactions with the impinging target atoms will occur at the surface of the substrate, enabling the formation of compound materials such e.g. as oxides or nitrides.

In order to increase yield, to increase use of sputter material or to increase sputtering rates, etc. sputtering coaters have been developed wherein a single sputter system comprises a plurality of magnetron sputter units. Sputtering systems with multiple magnetron sputter units may be operated in DC or in AC or pulsed DC mode. While DC power supplies are very effective, the corresponding sputtering process seems more difficult to control in the case of reactive processes forming compound layers. The use of AC or pulsed DC sources enables better control of the sputter deposition, but the output is lower for the same primary input power of the DC power suply.

Some examples of magnetic configurations for magnetron sputtering are described below.

Yusupov et al. describes in "Elucidating the asymmetric behaviour of the discharge in a dual magnetron sputter deposition system" in Applied Physics Letters 98 (2011) 131502 a magnetron sputter deposition system wherein two magnetron sputter units are present and wherein the magnetrons are mounted in an opposing way. In this way, some magnetic field lines are shared between the targets of the two magnetron sputter units, so that the plasma is confined between the targets of both magnetrons. In US patent application 2003/089601 (Applied Materials), a magnetron sputter reactor with a rotatable magnetron is used for increasing a plasma density near a target. The magnetron sputter deposition reactor furthermore comprises a further magnetic configuration positioned outside a wall of the system and allowing obtaining a better uniformity of the sputtering process.

US2003/155236 and GB2340845 both describe a magnetron sputtering apparatus comprising a plurality of sputtering magnetrons and auxiliary magnets. US6488824 describes a sputtering apparatus and method for high rate deposition using dual and triple rotatable cylindrical magnetrons. WO91/14797 describes a magnetron sputter ion plating system with two or more magnetron assemblies spaced around a substrate. DE4202211 describes a double magnetron sputtering system.

Although numerous magnetic configurations are known, all having their specific advantages and disadvantages, there is still a need for magnetron sputter deposition systems allowing good plasma and electron confinement while using targets with possibly restricted dimensions.

### Summary of the invention

It is an object of embodiments of the present invention to provide good magnetron sputter deposition systems and methods of using these for performing sputter deposition.

The above objective is accomplished by a method and device according to the present invention.

The present invention relates to a sputter deposition magnetron system for sputtering material, the sputter deposition magnetron system comprising at least a first and a second sputter magnetron unit, the first respectively second sputter magnetron unit comprising a first respectively second magnet configuration and a first respectively second mounting element for mounting a target so that the magnetic field of the first respectively second magnet configuration contributes to the formation and confinement of a plasma allowing sputtering of the first respectively second target wherein the sputter deposition magnetron system furthermore comprises at least an extra magnet configuration distanced from the mounting element for targets, whereby the first, the second and the at least one extra magnet configuration are arranged for each contributing to a confined plasma configuration wherein at least part of the plasma and closed loop electron trajectories are shared across the first and second sputter magnetron unit, the shortest distance between target surfaces of different targets when supported by the magnetron sputter units being smaller than 100 mm. It is an advantage of embodiments according to the present invention that the at least one extra magnet configuration assists in sustaining the plasma shared across the first and second sputter magnetron unit, or confinement of such plasma.

It is an advantage of embodiments of the present invention that a high plasma density can be obtained. It is an advantage of embodiments of the present invention that, for a same power level, higher deposition rates of target materials can be obtained compared to state-of-the art magnetron configurations.

It is an advantage of embodiments of the current invention that a plasma may be realized and confined so that at least part of the plasma current is shared across the first and the second sputter target.

It is an advantage of embodiments of the current invention that electron movements, originating from the target surface, are being directed by the first, second and at least an extra magnet configuration so that at least some electrons are accelerated towards both targets surfaces before they are lost from the confinement. In other words, the first, second and at least one extra magnet may be positioned so as to, in operation, force the trajectory of at least part of the electrons taking part in the deposition process in such a way that these electrons are accelerated to the surface of both magnetrons. It is an advantage of embodiments of the current invention that electron movement can occur over a closed circuit running over different magnet configurations, i.e. electron movement can be generated by combined effort of various magnet configurations, some of them being linked to each of at least two targets and at least a third configuration not related to one of the targets.

It is an advantage of embodiments of the present invention that a high magnetic field strength, e.g. between 0.6 T and 2 T, preferably between 0.9 T and 1.5 T, can be realized at the target surface.

It is an advantage of embodiments of the current invention that magnetron sputter deposition systems can be provided that are compact.

The first and second sputter magnetron unit may be adapted for receiving tubular targets, the first magnet configuration being adapted for being positioned inside a first tubular target and the second magnet configuration being adapted for being positioned inside the second tubular target. It is an advantage of embodiments of the current invention that a high target utilization can be realized. It is an advantage of embodiments of the current invention that a stable magnetic field strength is realized during the lifetime of the target.

The first and/or second magnet configuration may be a single magnet element or a single magnet array. It is an advantage of embodiments of the present invention that a magnetron sputter deposition system can be provided wherein for each magnetron sputter unit only a single magnet element or a single magnet array extending in the length of the target is provided, while still allowing to obtain a sufficient high magnetic field near the target surface.

It is an advantage of embodiments of the current invention that, e.g. due to the fact that the system can operate with a single magnet element or a single magnet array extending in the length of the target, small target tubes can be used. The target tubes used can have a diameter in a range down to 70 mm, advantageously a tube diameter in a range down to 50 mm or even smaller.

It is an advantage of embodiments of the current invention that race track turns on a single target surface can be avoided, resulting in a stable sputtering process and an equal erosion of the target material. It is an advantage of embodiments of the current invention that excess erosion near the edges of the target material in tubes can be avoided.

It is an advantage of embodiments of the current invention that the plasma zone may be a single longitudinal area extending along the length of the two magnetron targets and being located substantially in between the two targets.

It is an advantage of embodiments of the current invention that the plasma zone may be a longitudinal closed loop race-track area extending along the length of the two magnetron targets and one side being located substantially above the first target and the other side being located substantially above the second target.

It is an advantage of embodiments of the current invention that the plasma zone may consist of several areas, e.g. three of which one is located substantially above the first target, another plasma being located substantially above the second target and a third plasma being located substantially in an area between the two targets. According to an embodiment of the present invention, the first and/or the second magnetic configuration may comprise two magnetic elements or a double magnet array.

According to yet another embodiment of the present invention, the first and/or the second magnetic configuration may comprise three magnetic elements or a triple magnet array.

The first, the second and the at least one extra magnet configuration may be arranged such that the extra magnet configuration has an axis along the north-south orientation of at least one magnet array thereof making an angle of at least 45° with the axis along the north-south orientation of at least one magnet array of the first and the second magnet configurations. The orientation of the magnet arrays described above thereby may be considered for a view perpendicular to the longitudinal direction of the magnetron.

The first, the second and the at least extra magnet configuration may be arranged such that at least some of the magnetic field lines close by running over the at least three magnet configurations.

The magnetron sputter deposition system furthermore may comprise soft iron pole pieces positioned adjacent the magnetron sputter units and the extra magnetic configuration for forcing the magnetic field lines to close over the at least three magnet configurations.

The magnet configurations of the first and the second magnetron sputter units may be magnet configurations having opposing polarity.

The magnet configurations may be arranged so that at least 10% of the magnetic field lines of individual arrays within the magnetron sputter units may be shared between at least three magnet configurations.

The magnet configurations of the at least two magnetron sputter units may be arranged so that at least 10% of the magnetic field lines of at least one of the arrays are shared with at least one array of another magnet configuration.

The shortest distance between target surfaces of different targets when supported by the magnetron sputter units is be smaller than 100 mm, preferably even smaller than 50 mm.

The at least one extra magnet configuration may be arranged so as to be located at least 1cm away from the targets, when mounted in the sputter deposition magnetron system.

The first the second and the at least one extra magnet configuration are positioned so as to provide a single dense plasma between the different sputter magnetron units.

According to some embodiments, the first and the second sputter magnetron units may be elongated magnetron units positioned such that their end portions are located near each other, wherein the first and the second magnet configuration may be arranged to confine a plasma near the first and the second sputter magnetron unit respectively and wherein the at least one extra magnet configuration may comprise a magnet configuration positioned near each side of the elongated magnetron units for transferring electrons between the different magnetron sputtering units.

The first, the second and the at least one extra magnet configuration may be arranged such that the extra magnet configuration has an axis along the north-south orientation of at least one magnet array thereof making an angle of less than 45° with the axis along the north-south orientation of at least one magnet array of the first and the second magnet configurations. The orientation of the magnet arrays described above thereby may be considered for a view perpendicular to the longitudinal direction of the magnetron.

The first and the second magnet configuration may be parallel magnet configurations. The sputter deposition magnetron system furthermore may comprise a tuning mechanism for adjusting the position of the at least one extra magnet configuration. It is an advantage of embodiments of the present invention that tuning of the magnet field can be performed using the magnetron sputter deposition system. It is an advantage of embodiments of the present invention that the magnetic field can be tuned by tuning the at least one extra magnet configuration, which can be positioned at a more easily accessible position than the other magnetic configurations. It is an advantage of embodiments of the current invention that the magnetic field lines, and thus the plasma density, can be tuned without breaking the vacuum or without the need for removing the water from the target, or without the need for removing the target.

The tuning mechanism may comprise any of a positioning mechanism for adjusting the position of the at least one extra magnet configuration or an electric or a magnetic field generator or a shunting mechanism for adjusting the at least one extra magnet configuration.

The sputter deposition magnetron system furthermore may comprise a tuning mechanism for adjusting the first and/or the second magnet configuration.

In one aspect, the present invention also relates to a vacuum deposition apparatus, the vacuum deposition apparatus comprising a vacuum chamber, a substrate holder for positioning a substrate to be coated in the vacuum chamber and a magnetron sputter deposition system as described above.

Use of a magnetron deposition system as described above for providing a coating on a surface of an object and/or for performing plasma etching.

The use may furthermore comprise tuning for adjusting the at least one extra magnet configuration for adjusting the magnetic field configuration in the system.

Particular and preferred aspects of the invention are set out in the accompanying independent and dependent claims. Features from the dependent claims may be combined with features of the independent claims and with features of other dependent claims as appropriate and not merely as explicitly set out in the claims. These and other aspects of the invention will be apparent from and elucidated with reference to the embodiment(s) described hereinafter.

### Brief description of the drawings

FIG. 1 provides an overview of a system for sputtering target material, according to an embodiment of the current invention.
FIG. 2A to FIG. 2F illustrates different magnetic configurations as can be used according to embodiments of the present invention, wherein FIG. 2A illustrates magnet configurations comprising one magnet element or magnet array, FIG. 2B and
FIG. 2C illustrate magnet configurations comprising two magnet elements or magnet arrays and FIG. 2D to FIG. F illustrates magnet configurations comprising three magnet elements or magnet arrays.
FIG. 3 provides a schematic cross-sectional overview of a system for sputtering target material whereby tubular targets are used, according to an embodiment of the current invention.
FIG. 4 illustrates the magnetic field lines realized by a system according to an embodiment of the present invention, more specifically a system as schematically shown in FIG. 3.
FIG. 5 illustrates a schematic cross-sectional overview of an alternative system for sputtering target material using tubular targets and an extra magnetic configuration at the end regions of the targets for sharing the plasma over the tubular targets, according to an embodiment of the present invention.
FIG. 6 illustrates the magnetic field lines realized by a system according to an embodiment of the present invention, more specifically a system as schematically shown in FIG. 5.
FIG. 7 illustrate a schematic top view of a system for sputtering target materials using the principle shown in FIG. 5, whereby the magnet configuration per target a single magnet array, according to an embodiment of the present invention.
FIG. 8 and FIG. 9 illustrate a schematic top view and front view of a system for sputtering target materials using the principle shown in FIG. 5, whereby the magnet configuration per target is a dual magnet array, according to an embodiment of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to a magnetron sputter deposition system, reference is made to an assembly of at least two magnetron sputter units each suitable for supporting a target from which material can be sputtered. The magnetron sputter deposition system optionally also may comprise other components.

Where in embodiments of the present invention reference is made to a magnetron sputter unit reference is made to a combination of a magnet configuration and a target holder with a mounting element for mounting a single target. Optionally also other components also can be included as will be described further.

Where in embodiments of the current invention reference is made to "a magnet configuration" reference is made to one or more magnet elements or magnet arrays positioned near one and the same sputter targets.

Where in embodiments of the present invention, reference is made to a confined plasma, reference is made to a plasma wherein electrons are trapped in the area where sputtering is to be performed.

Where in embodiments of the current invention reference is made to closing of magnetic field lines, reference is made to magnetic field lines that form a closed line over the magnet configurations of the two magnetron sources and over at least a third independent magnet configuration present in the system. It is to be noticed that not necessarily all magnet field lines of the separate magnet configurations need to close. For example, at least a few percent of the magnetic field lines, more advantageously 10% of the magnetic field lines could be shared between different magnet configurations in the system or in some configuration up to or above 25% of the magnetic field lines of well-defined arrays in the magnetic configuration.

Where in embodiments of the current invention reference is made to "a mounting element" reference is made to an element for mounting a target. Depending on the target to be mounted, for example a tubular or planar target, different mounting elements may exist. According to embodiments of the present invention, the magnet configuration typically may be positioned under the target, i.e. at a side of the target opposite the face of the target that is being sputter eroded. The magnet configuration may typically be positioned at the same side as a cooling circuit used for cooling the target during sputtering. The magnet configuration and the cooling circuit thus typically may be positioned at the same face of the target, i.e. opposite the face of the target that is being sputter eroded.

In a first aspect, embodiments of the present invention relate to a magnetron sputter deposition system suitable for depositing a coating or layer on an object such as for example a substrate or for plasma treatment of an object. The substrate to be coated or treated may be a conventional plate-like substrate, may be a sheet-like material, may be one or more 3-dimensional objects, etc. The sputtering method typically is a physical vapor deposition (PVD) process. It is to be noticed that embodiments of the present invention are not limited by the type of substrates, targets or gasses that may be used. According to embodiments of the present invention, the system comprises a topology of at least three magnet configurations. As will be illustrated, the number of magnet configurations also may be larger than three, such as for example, four, five or more. The sputter deposition magnetron system comprises at least a first and a second sputter magnetron unit comprising a first respectively second magnet configuration and a first respectively second mounting element for mounting a target so that the magnetic field of the first respectively second magnet configuration contributes to the formation and confinement of a plasma zone allowing sputtering of the first respectively second target. As indicated above, the magnet configurations and the mounting elements for targets typically may be positioned such that the magnet configurations are behind the targets, i.e. at a face of the targets opposite to the face of the targets that is being sputter eroded during use. The sputter deposition magnetron system furthermore comprises at least one extra magnet configuration distanced from the mounting element for targets, such as for example not behind the target, i.e. at the face of the target that is being cooled. The first, the second and the at least one extra magnet configuration are arranged for each contributing to a confined plasma configuration wherein at least part of the plasma is shared across the first and the second sputter magnetron unit.

In embodiments of the present invention, electron movements, originating from the target surface, may be directed by the first, second and at least an extra magnet configuration so that at least some electrons are accelerated towards both targets surfaces before they are lost from confinement. The electron movement can occur over a closed circuit running over different magnet configurations, i.e. electron movement can be generated by combined effort of various magnet configurations, some of them being linked to each of at least two targets and at least a third configuration not related to one of the targets.

According to some embodiments of the present invention, at least some of the magnetic field lines may close by running over all of the first magnet configuration, the second magnet configuration and at least one extra magnet configuration. In some embodiments, at least some of the magnetic field lines may close by running over each and all of the magnet configurations in the system.

According to embodiments of the present invention, sharing at least part of the plasma across the at least first and second sputter magnetron unit can be obtained in at least two different ways. The magnet configurations can in one way be arranged such that the electrons are confined so that they are continuously being shared between the different sputter magnetron units. A single plasma cloud then is shared between the different sputter magnetron units. Alternatively, the magnet configurations can be arranged such that the electrons are confined such that they are alternatingly running along the length of the different sputter magnetron units and are mainly shared between the different sputter magnetron units by transferring them between the different sputter magnetron units in the end regions of the units. By sharing the electrons between the different sputter magnetron units over time, a confined plasma can be sustained. Although different denser plasma regions will be distinguishable at the different sputter magnetron units, the plasma thereby still is a shared plasma as a drop of the plasma at one sputter magnetron unit immediately implies a drop of the plasma at the other sputter magnetron unit(s). In practice, if the power supply is disconnected from at least one of the sputter magnetron units, the plasma may disappear completely or will be at least very heavily distorted.

In embodiments of the present invention, the at least one extra magnet configuration contributes to the steady state plasma. In at least some of the embodiments, the presence of the at least one extra magnet configuration typically also results in a denser plasma, as the at least one extra magnet configuration assists in obtaining a higher magnetic field near the different targets.

By way of illustration, embodiments of the present invention not being limited thereto, the different ways of sharing the plasma over the sputter magnetron units using the at least one extra magnet configuration will further be discussed with reference to the drawings.

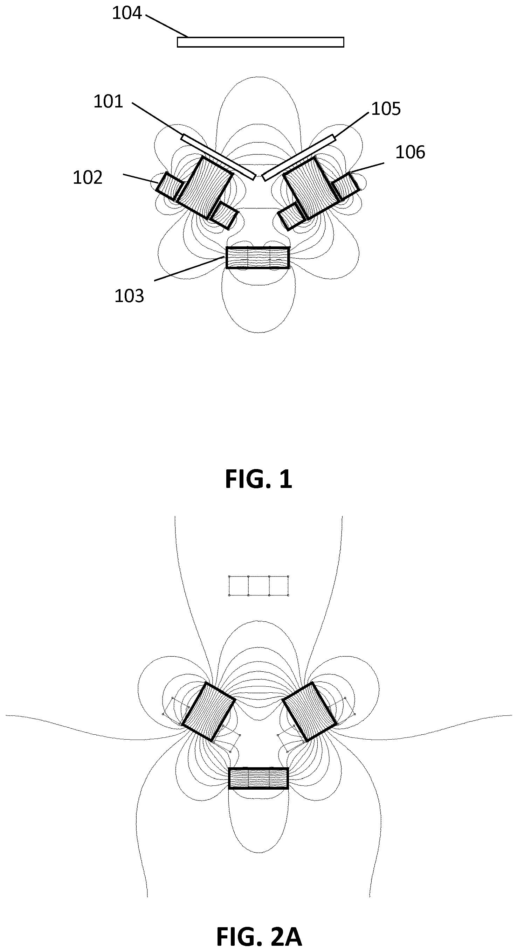

By way of illustration, not being limited thereby, FIG. 1 shows a schematic overview of a configuration whereby electrons are simultaneously and continuously shared between the different sputter magnetron units. Magnet configurations 102, 106 and 103 are placed in such a topology that at least part of the magnetic field lines close over the respective magnet configurations. In particular embodiments, at least 10%, in some embodiments at least 25%, of the magnetic field lines are shared between at least one array of the first sputter magnetron unit and at least one array of the second sputter magnetron unit, i.e. are common between neighbouring magnet configurations. In such embodiments, all of the first, second and third magnet configurations may share magnetic field lines and at least part of the magnetic field lines may close by running over each and all of the magnet configurations. First and second magnet configurations 102 and 106 are positioned such that a plasma allowing sputtering is confined by the magnet field lines between magnet configuration 102 and 106. For sputtering, a target material 101 typically is positioned in front of the first magnet configuration 102 in the region where the plasma is induced when sputtering is performed. A second target material 105 typically is positioned in front of magnet configuration 106 in the region where the plasma is induced when sputtering is performed. The magnet configurations thus typically are positioned behind the targets, i.e. at a face of the target opposite the face that is eroded by sputtering. Typically at this face, also cooling of the target can be performed. By positioning a substrate 104 so that the substrate 104 can directly see the target surfaces of the targets where sputtering is performed using the first and second magnet configurations 102 and 106, a coating can be sputtered on the substrate. In contrast to magnet configurations 102 and 106 that are positioned close to a target holder and generate a magnetic field close to the two targets, the extra magnet configuration 103 is separate from a specific target. The extra magnet configuration 103 may be positioned on a plurality of positions, such as for example below the sputter magnetron units opposite to the substrate, behind the substrate, etc. In some embodiments of the current invention, the extra magnet configuration 103 is separated at least 1 cm, advantageously at least 2 cm or even further away from the targets when mounted. In all the embodiments according to the invention, the first and second magnetic configurations are arranged so that the shortest distance between neighbouring targets, when mounted on the target support of neighbouring magnetron sputter units, is smaller than 100 mm, advantageously smaller than 50 mm.

The latter may assist in having an increased amount of magnetic field lines shared between the two magnetron sputter units. The third magnet configuration 103 allows to support magnetic field lines closing over the different magnet configurations, which is especially advantageous when only a single magnet element or a single magnet array is used in each of the first and second magnet configuration, but also can be used when double magnet elements or magnet arrays are used or even triple magnet elements or magnet arrays are used. It is to be noticed that the one or more magnetic configurations may also have more than three magnet elements or magnet arrays.

By way of illustration, embodiments of the present invention not being limited thereto, a number of magnet configurations, illustrating the principle, are shown schematically in FIG. 2A to FIG. 2F indicating examples of simulations of different magnetic field lines for different magnet configurations according to embodiments of the present invention. In the drawings which represent a cross section of the magnetic configuration of the complete magnetron-set up - the set up typically extending in a direction perpendicular to the cross-sectional direction, the different magnetic field lines are shown, as well as possible magnet array positions - indicated as rectangular blocks - in the magnet configurations, whereby the magnet array positions are indicated with thick lines correspond with magnet arrays being present in the shown configuration, whereas magnet array positions indicated with thin lines correspond with magnet arrays being absent in the shown configurations. In FIG. 2A, a first and second neighbouring magnet configuration is shown, consisting of a single magnet or magnet array. The extra magnet configuration also is a single magnet or magnet array. The first and second magnet configurations thereby have an opposed pole configuration, resulting in magnet field lines not only closing within the magnet configurations themselves but also sharing magnet field lines between the first and second magnet configurations. Due to the particular magnet configuration, the magnetic field lines according to the embodiment of the present invention close over the three magnet configurations. It is to be noticed that, when sputtering using a single magnet element or magnet array, the erosion zone at the different targets can be limited to a single erosion line, resulting in the fact that no turns are present in the erosion tracks. As turns typically erode in a different way than other portions of the erosion track, the present embodiment may due to the absence of the turns result in a more uniform eroding of the target.

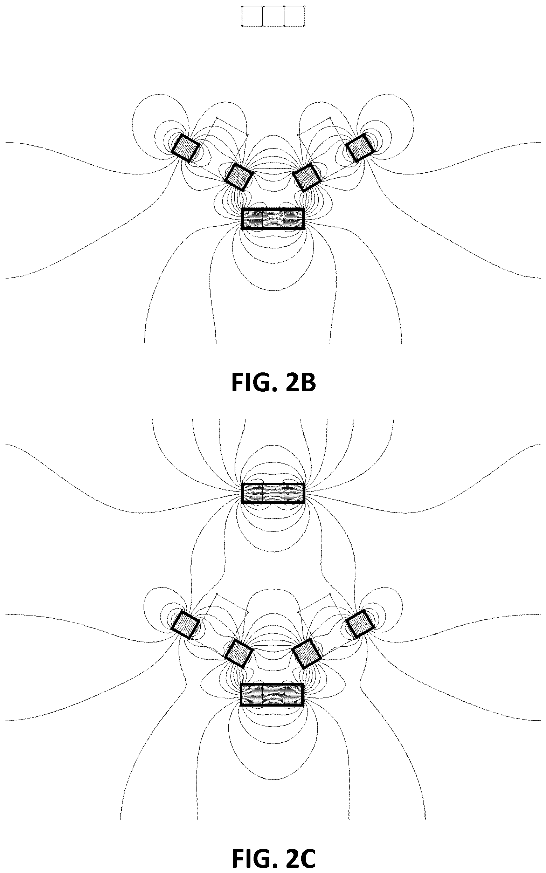

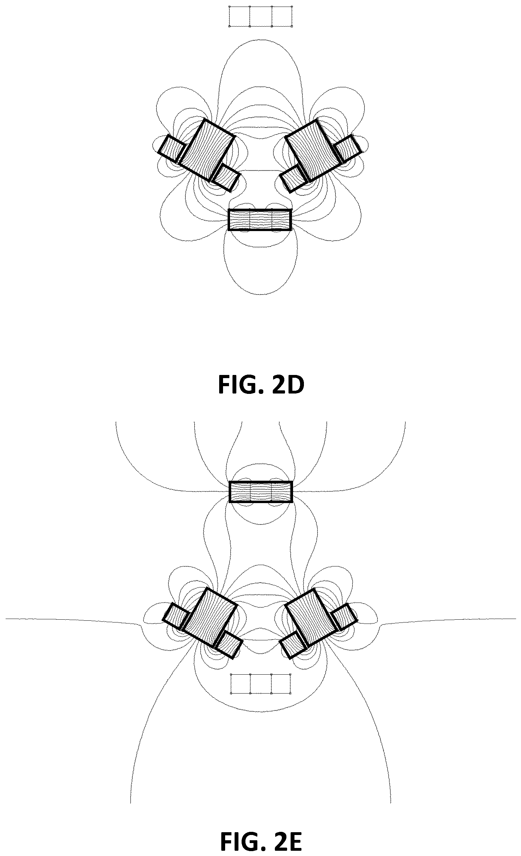

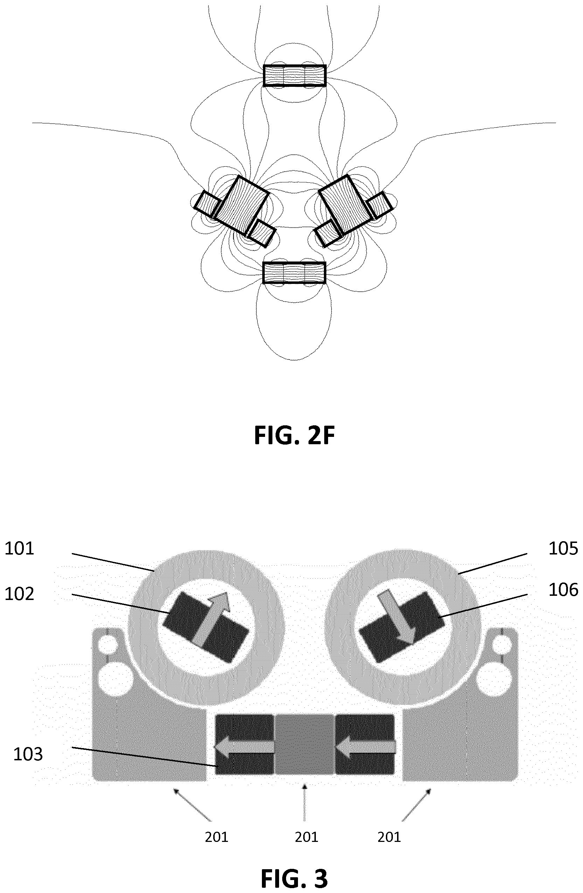

A similar situation can be seen in FIG. 2B and FIG. 2C where for each magnet configuration a dual magnet or dual magnet array is provided, and whereby again magnet field lines close by running over the three magnet configurations. In FIG. 2B and FIG. 2C two different configurations are shown, whereby in FIG. 2B the extra magnet configuration is positioned at the opposite side of the magnet sputter units than the substrate, whereas in FIG. 2C the extra magnet configuration is positioned such that the substrate is in between the different magnet configurations. The latter situation may e.g. be especially suitable if a plasma treatment application for the substrate is envisaged. FIG. 2D to FIG. 2F illustrate the corresponding situation for three magnets or three magnet arrays per magnet configuration, showing the same features of at least some magnet field lines closing by running over all of the different magnet configurations. In FIG. 2D and FIG. 2E simulation of a system is shown whereby one extra magnet configuration is provided, whereas in FIG. 2F simulation is shown of a system comprising two extra magnet configurations.

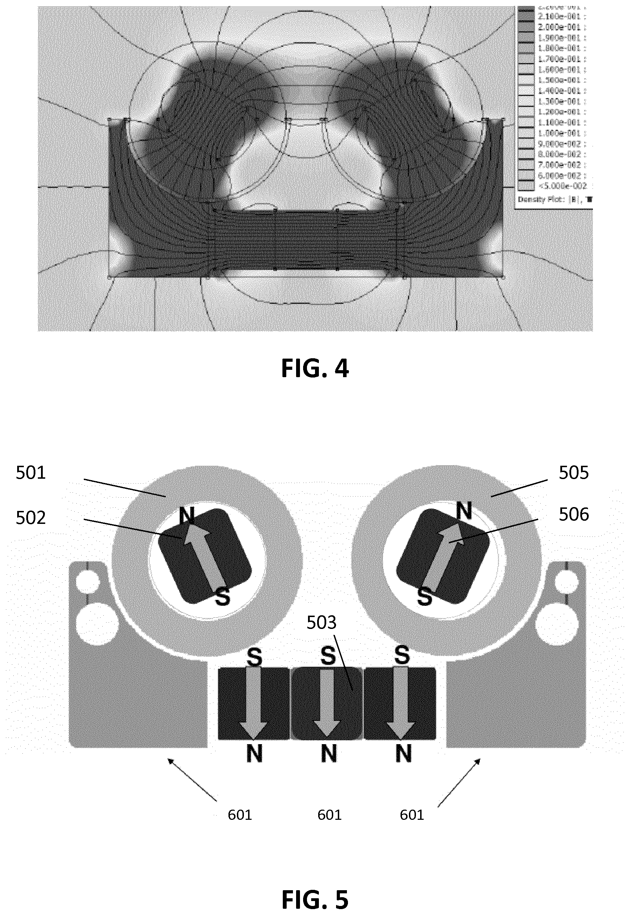

In a particular embodiment, the present invention relates to a system as described with reference to FIG. 1, but wherein the planar targets shown in FIG. 1 are replaced by tubular targets 101 and 105, as illustrated in FIG. 3. The magnet configurations 102 and 106 are then positioned inside the targets. Such embodiment can advantageously make use of magnet configurations wherein only a single magnet element or magnet array is present per magnet configuration. A single magnet element in the target allows to build smaller target tubes allowing to build a compact system. The tubular targets can e.g. have a diameter in a range downto 8cm, e.g. even a range downto 4cm. Again at least part of the magnetic field lines are closed over magnetic configurations 102, 103 and 106. FIG. 4 schematically illustrates the magnetic field lines resulting from the magnet configurations positioned such as schematically illustrated in FIG. 3. It can be noticed that a high magnetic field and consequently a high sputter yield can be obtained.

According to some embodiments of the present invention, the magnetron sputter deposition systems may additionally comprise soft magnetic material, such as e.g. soft iron pole pieces 201 or any convenient material with high magnetic permeability, for assisting in forcing the magnetic field lines close over the different magnet configurations. An exemplary embodiment having soft iron pole pieces is schematically illustrated in FIG. 3.

According to embodiments of the present invention, the system may additionally comprise an adjusting means for adjusting the magnetic configuration of the magnetron sputter deposition system. Advantageously, in embodiments of the present invention, a magnet configuration besides the first and the second is adjusted, as this extra magnet configuration typically is more easily adjustable than the first magnet configuration and/or second magnet configuration, as the latter typically are connected to a target holder and therefore are surrounded with a number of other components, such as for example cooling elements. The adjusting means may for example be a mechanical means for moving an individual magnet configuration, an electric field generating means for influencing an individual magnet configuration electrically, a magnetic field generating means for influencing an individual magnet configuration magnetically, a shunting means etc. By adjusting an individual magnetic configuration and due to the fact that this impacts the overall plasma confinement, the performance of the full magnetron sputter deposition system can be adjusted. The latter can in advantageous embodiments be done without the need for directly influencing the first or the second magnet configurations. By changing the magnetic field configuration, the plasma can be changed and the sputtering can be tuned. Adjustment can in some embodiments be obtained without the need for opening the vacuum system. As the at least one extra magnet configuration can be adjusted, it is thus also not necessary to remove a target or to remove the cooling to modify the magnetic field lines.

In the first group of embodiments described above, the extra magnet configuration may have an axis along the north-south orientation of at least one magnet array thereof advantageously making an angle of at least 45° with the axis along the north-south orientation of at least one magnet array of the magnet configurations linked to the sputter magnetron units - as seen in a cross-section perpendicular to the longitudinal extent of the magnetron configuration.

In the following portion, embodiments will be described by way of example, illustrating configurations wherein extra magnet configurations are used for sharing the plasma, by positioning them at end portions of the sputter magnetron unit for creating shared magnetic field lines between the different sputter magnetron units. Such embodiments advantageously make use of elongated sputter magnetron units, e.g. making use of rotatable sputter targets.

By way of illustration, FIG. 5 shows a schematic cross-sectional overview of a system whereby electrons are confined above each of the sputter magnetron units and shared alternatingly over the different sputter magnetron units. Sharing of electrons, and thus the plasma, thereby is induced by the presence of extra magnet configurations positioned at or near the end of the elongated sputter magnetron units. Typically two such further magnet configurations may be provided, one for each end portion of the elongated targets. The elongated target thereby typically may be positioned parallel to each other, such that their end portions are located close to each other.

The magnet configurations linked to the magnetron sputter units 502, 506 and the extra magnet configuration 503 positioned along the elongated sputter magnetron units, are placed in such a topology that a confined plasma configuration is maintained wherein at least part of the plasma is shared across the first and the second sputter magnetron unit. In embodiments according to the principle illustrated in FIG. 5, sharing of the plasma is obtained by transferring electrons generating part of the plasma above a first sputter magnetron unit to part of the plasma above the second sputter magnetron unit and vice versa. According to at least some embodiments, the different magnet configurations are such that at least some electrons are accelerated towards both target surfaces before they are lost from confinement. The electron movement thereby occurs over a closed circuit running over different magnet configurations, i.e. electron movement can be generated by combined effort of various magnet configurations, some of them being linked to each of at least two targets and at least a third configuration not related to one of the targets. The magnetic configurations thus induce that - during operation - electrons form a closed loop trajectory that forces them to pass the surface of the two magnetron configurations consecutively, before returning at their starting position. The extra magnet configurations 503 may be positioned such that it is separated at least 1 cm, advantageously at least 2cm or even further from the targets when mounted. For sputtering, a target material 501 typically is positioned in front of the first magnet configuration 502 in the region where part of the plasma is induced when sputtering is performed. A second target material 505 typically is positioned in front of magnet configuration 506 in the region where part of the plasma is induced when sputtering is performed. The magnet configurations linked to the sputter magnetron units thus typically are positioned behind the targets, i.e. at a face of the target opposite the face that is eroded by sputtering. Typically at this face, also cooling of the target can be performed. By positioning a substrate (not shown) so that the substrate can directly see the target surfaces of the targets where sputtering is performed using the first and second magnet configurations 502 and 506, a coating can be sputtered on the substrate or plasma treatment of the substrate can be performed.

As indicated, extra magnet configurations may be positioned along the elongated sputter magnetron units and certainly near the end of the elongated sputter magnetron units, i.e. one configuration per end side of two sputter magnetron units.. It may for example be positioned below the sputter magnet configurations and/or in between the sputter magnetron configurations.

According to at least some embodiments of the present invention, the extra magnet configuration may be oriented such that the axis along the north-south direction of at least one magnet array thereof makes an angle smaller than 45° with the axis along the north-south direction of a magnet array of the magnet configurations linked to the magnetron sputter units - as seen in a cross-section perpendicular to the longitudinal extent of the magnetron configuration.

The different magnet configurations may consists of a single magnet element or a single magnet array, but alternatively also more single magnets or magnet arrays may be present per magnet configuration.

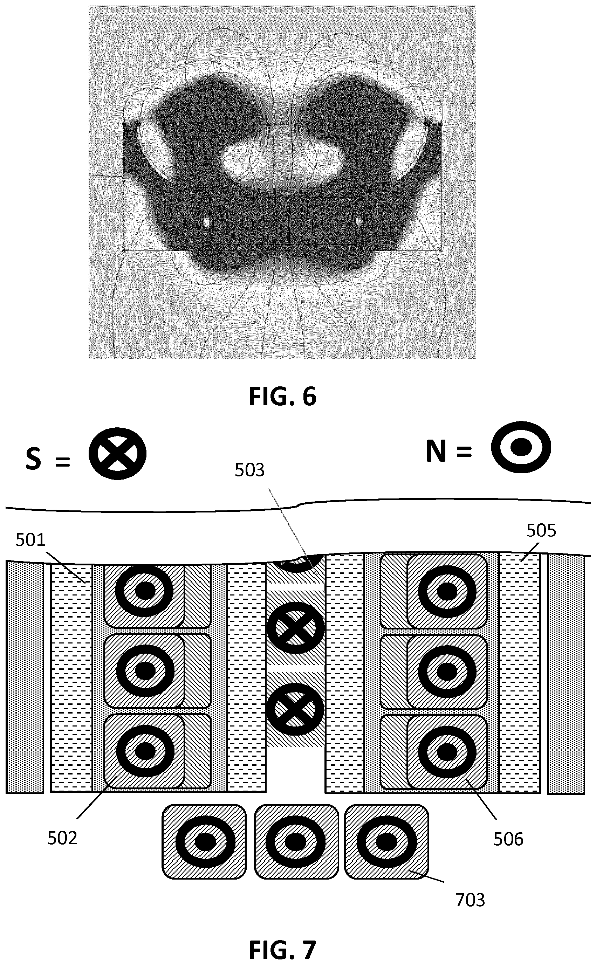

FIG. 6 illustrates simulated magnetic field lines for a configuration as shown in FIG. 5. By way of illustration, embodiments of the present invention not being limited thereto, FIG. 7 illustrates a top view of the end portion of a sputtering system respectively a front view, whereby the different magnet configurations are illustrated. In FIG. 7, a first magnet configuration 502 linked to a first rotatable sputter target 501 and a second magnet configuration 506 linked to a second rotatable sputter target 502 is shown, in the present example being a single magnet array per target. In between the targets a first additional magnet array 503 is provided assisting in confinement of the plasma near the targets. This first additional magnet array typically may extend along the length of the sputtering system. Further magnet configurations 703 are positioned near the end portions of the sputter magnetron units - i.e. typically only located at the end portions - resulting in magnetic field lines closing over the end portions of the different sputter magnetron units by running over the further magnet configurations. Electrons thus can be accelerated from one target to another target as they are forced to turn by the further magnet configurations positioned near the end portions.

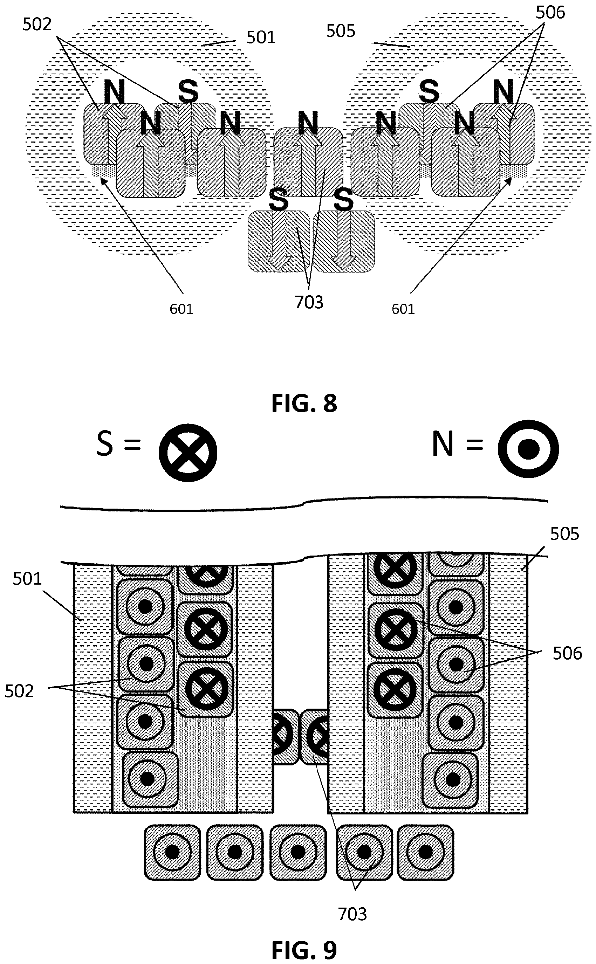

An alternative configuration is shown in FIG. 8 and FIG. 9 illustrating a top view of the end portion of a sputtering system respectively a front view. In this alternative configuration, a dual magnet array per sputter magnetron unit is illustrated. In this case, a first magnet configuration 502 linked to a first rotatable target 501 and a second magnet configuration 506 linked to a second rotatable target 502 is shown, each consisting of a dual magnet array. Furthermore, extra magnet configurations 703 are provided located near the end portions of the sputter magnetron units and arranged such that electron trajectories are defined - in operation - forming a closed loop race track for electrons partially positioned close to the surface of the first magnetron unit and partially positioned close to the surface of the second magnetron. In the example shown in FIG. 8 and FIG. 9, the extra magnet configurations 703 also are dual magnet arrays. In FIG. 5 and FIG. 8, also soft magnetic material 601 is shown, further assisting in confining the magnetic field.

It is to be notice that the particular examples shown in the drawings are not to be considered as being limiting the invention, the invention only being limited by the claims.

In another aspect, the present invention relates to a vacuum apparatus for plasma coating or plasma treatment of an object, e.g. of a surface of an object. Such an apparatus typically may comprise a vacuum chamber, a substrate holder for positioning a substrate and a magnetron sputter deposition system as described in embodiments of the first aspect. It is to be noticed that the apparatus typically also may comprise a number of other standard and optional components such as for example a vacuum pump, shutters, windows, cooling elements, heating elements, etc., these elements not being described in more details as these are not essential to the characterizing elements of the present invention and as these are known by the person skilled in the art.

In yet another aspect, the present invention relates to the use of a magnetron sputter deposition system as described in the first aspect for depositing a coating on an object or for plasma treatment of an object. Such a use typically may be performed in a vacuum system. The method advantageously may make use of an easier accessibility of the magnet configuration beyond the ones linked to the individual first and second magnetron for controlling the magnetic configuration of the full system through the at least one extra magnet configuration, although embodiments of the present invention are not limited thereto. Further method steps of the use may correspond with the functionality of one or more of the components described in the first aspect of the present invention.

## Claims

1. A sputter deposition magnetron system for sputtering material, the sputter deposition magnetron system comprising
at least a first and a second sputter magnetron unit, the first respectively second sputter magnetron unit comprising a first respectively second magnet configuration (102, 106) and a first respectively second mounting element for mounting a target (101, 105) so that the magnetic field of the first respectively second magnet configuration (102, 106) contributes to the formation of a plasma allowing sputtering of the first respectively second target (101, 105),
wherein the sputter deposition magnetron system furthermore comprises at least an extra magnet configuration (103) distanced from the mounting element for targets, wherein the first, the second and the at least one extra magnet configuration are arranged for each contributing to a confined plasma configuration **characterized in that**, in operation, at least part of the plasma and closed loop electron trajectories are being shared across the first and the second sputter magnetron unit, and the shortest distance between target surfaces of different targets when supported by the magnetron sputter units being smaller than 100 mm.

2. A sputter deposition magnetron according to claim 1, wherein the first, second and at least one extra magnet are positioned so as to, in operation, force the trajectory of at least part of the electrons taking part in the deposition process in such a way that these electrons are accelerated to the surface of both magnetrons.

3. A sputter deposition magnetron system according to any of the previous claims, wherein the first and/or second magnet configuration is a single magnet element or a single magnet array.

4. A sputter deposition magnetron system according to any of claims 1 to 2, wherein the first and/or the second magnet configuration is a double magnet element or a double magnet array.

5. A sputter deposition magnetron system according to any of the previous claims, wherein the first, the second and the at least one extra magnet configuration are arranged such that the extra magnet configuration has an axis along the north-south orientation of at least one magnet array thereof making an angle of at least 45° with the axis along the north-south orientation of at least one magnet array of the first and the second magnet configurations.

6. A sputter deposition magnetron system according to claim 5, wherein the first, second and at least one extra magnet configuration are positioned such that at least a part of the magnetic field lines in the system close by running over the first, the second and the at least one extra magnet configuration.

7. A magnetron sputter deposition system according to claim 6, wherein the magnet configurations of the at least two magnetron sputter units are arranged so that at least 10% of the magnetic field lines of individual arrays within the magnetron sputter units are shared between different magnet configurations.

8. A magnetron sputter deposition system according to any of the previous claims, wherein the magnet configurations of the first and the second magnetron sputter units are having opposing magnet polarity configurations.

9. A sputter deposition magnetron system according to any of the previous claims, wherein the first the second and the at least one extra magnet configuration are positioned so as to provide a single dense plasma between the different sputter magnetron units.

10. A sputter deposition magnetron system according to any of claims 1 to 4,wherein the first and the second sputter magnetron units are elongated magnetron units positioned such that their end portions are located near each other, wherein the first and the second magnet configuration is arranged to confine a plasma near the first and the second sputter magnetron unit respectively and wherein the at least one extra magnet configuration comprises a magnet configuration positioned near each side of the elongated magnetron units for transferring electrons between the different magnetron sputtering units.

11. A sputter deposition magnetron system according to claim 10, wherein the first, the second and the at least one extra magnet configuration are arranged such that the extra magnet configuration has an axis along the north-south orientation of at least one magnet array thereof making an angle of less than 45° with the axis along the north-south orientation of at least one magnet array of the first and the second magnet configurations.

12. A sputter deposition magnetron system according to any of claims 10 to 11, wherein the first and the second magnet configuration are parallel magnet configurations.

13. A sputter deposition magnetron system according to any of the previous claims, the sputter deposition magnetron system furthermore comprising a tuning mechanism for adjusting the at least one extra magnet configuration, wherein the tuning mechanism comprises any of a positioning mechanism for adjusting the position of the at least one extra magnet configuration or an electric or a magnetic field generator for adjusting the at least one extra magnet configuration or a shunting mechanism of the at least one extra magnetic configuration.

14. A vacuum deposition apparatus for sputtering, the vacuum deposition apparatus comprising a vacuum chamber, a substrate holder for positioning a substrate to be coated in the vacuum chamber and a magnetron sputter deposition system as described in any of claims 1 to 13.

15. Use of a magnetron sputter deposition system according to any of claims 1 to 13 for providing a coating on a surface of an object or for plasma treatment of an object.

## Patentansprüche

1. Sputteraufbringungsmagnetronsystem zum Sputtern von Material, wobei das Sputteraufbringungsmagnetronsystem umfasst:
zumindest eine erste und eine zweite Sputtermagnetroneinheit, wobei die erste bzw. zweite Sputtermagnetroneinheit eine erste bzw. zweite Magnetkonfiguration (102, 106) und ein erstes bzw. zweites Montageelement zum Montieren eines Ziels (101, 105) umfassen, sodass das Magnetfeld der ersten bzw. zweiten Magnetkonfiguration (102, 106) zu der Bildung eines Plasmas beitragen, welches Sputtern des ersten bzw. zweiten Ziels (101, 105) erlaubt,
wobei das Sputteraufbringungsmagnetronsystem weiter zumindest eine zusätzliche Magnetkonfiguration (103) umfasst, welche von dem Montageelement für Ziele beabstandet ist, wobei
die erste, die zweite und die zumindest eine zusätzliche Magnetkonfiguration angeordnet sind, um jeweils zu einer begrenzten Plasmakonfiguration beizutragen, **dadurch gekennzeichnet, dass** im Betrieb zumindest ein Teil des Plasmas und Elektronenbahnen in geschlossener Schleife zwischen der ersten und der zweiten Sputtermagnetroneinheit geteilt werden, und
der kleinste Abstand zwischen Zielflächen von unterschiedlichen Zielen, wenn durch die Sputtermagnetroneinheiten unterstützt, kleiner als 100 mm sind.

2. Sputteraufbringungsmagnetronsystem nach Anspruch 1, wobei der erste, zweite und zumindest eine zusätzliche Magnet so positioniert sind, dass sie im Betrieb die Bahn von zumindest einem Teil der Elektronen, welche an dem Aufbringungsprozess teilnehmen, auf eine solche Art zwingen, dass diese Elektronen zu der Fläche von beiden Magnetronen beschleunigt werden.

3. Sputteraufbringungsmagnetronsystem nach einem der vorstehenden Ansprüche, wobei die erste und/oder zweite Magnetkonfiguration ein einzelnes Magnetelement oder eine einzelne Magnetanordnung ist.

4. Sputteraufbringungsmagnetronsystem nach einem der Ansprüche 1 bis 2, wobei die erste und/oder zweite Magnetkonfiguration ein doppeltes Magnetelement oder eine doppelte Magnetanordnung ist.

5. Sputteraufbringungsmagnetronsystem nach einem der vorstehenden Ansprüche, wobei die erste, die zweite und die zumindest eine zusätzliche Magnetkonfiguration angeordnet sind, sodass die zusätzliche Magnetkonfiguration eine Achse entlang der Nord-Süd-Ausrichtung der zumindest einen Magnetanordnung davon aufweist, wodurch ein Winkel von zumindest 45° mit der Achse entlang der Nord-Süd-Ausrichtung der ersten und der zweiten Magnetkonfiguration gebildet wird.

6. Sputteraufbringungsmagnetronsystem nach Anspruch 5, wobei die erste, zweite und zumindest eine zusätzliche Magnetkonfiguration positioniert sind, sodass zumindest ein Teil der Magnetfeldlinien in dem System in der Nähe über die erste, die zweite und die zumindest eine zusätzlich Magnetkonfiguration führen.

7. Magnetronsputteraufbringungssystem nach Anspruch 6, wobei die Magnetkonfigurationen in den zumindest zwei Magnetronsputtereinheiten angeordnet sind, sodass zumindest 10 % der Magnetfeldlinien von individuellen Anordnungen innerhalb der Magnetronsputtereinheiten zwischen unterschiedlichen Magnetkonfigurationen geteilt werden.

8. Magnetronsputteraufbringungssystem nach einem der vorstehenden Ansprüche, wobei die Magnetkonfigurationen der ersten und zweiten Magnetronsputtereinheit entgegengesetzte Magnetpolarisierungskonfigurationen aufweisen.

9. Sputteraufbringungsmagnetronsystem nach einem der vorstehenden Ansprüche, wobei die erste, die zweite und die zumindest eine zusätzliche Magnetkonfiguration so positioniert sind, dass sie ein einzelnes dichtes Plasma zwischen den unterschiedlichen Sputtermagnetroneinheiten bereitstellen.

10. Sputteraufbringungsmagnetronsystem nach einem der Ansprüche 1 bis 4, wobei die erste und die zweite Sputtermagnetroneinheit längliche Magnetroneinheiten sind, welche so positioniert sind, dass ihre Endabschnitte sich nebeneinander befinden, wobei die erste und die zweite Magnetkonfiguration angeordnet sind, um ein Plasma nahe der ersten bzw. der zweiten Sputtermagnetroneinheit zu begrenzen, und wobei die zumindest eine zusätzliche Magnetkonfiguration eine Magnetkonfiguration umfasst, welche nahe jeder Seite der länglichen Magnetroneinheiten positioniert ist, um Elektronen zwischen den unterschiedlichen Magnetronsputtereinheiten zu transportieren.

11. Sputteraufbringungsmagnetronsystem nach Anspruch 10, wobei die erste, die zweite und die zumindest eine zusätzliche Magnetkonfiguration angeordnet sind, sodass die zusätzliche Magnetkonfiguration eine Achse entlang der Nord-Süd-Ausrichtung der zumindest einen Magnetanordnung davon aufweist, wodurch ein Winkel von weniger als 45° mit der Achse entlang der Nord-Süd-Ausrichtung der ersten und der zweiten Magnetkonfiguration gebildet wird.

12. Sputteraufbringungsmagnetronsystem nach einem der Ansprüche 10 bis 11, wobei die erste und zweite Magnetkonfiguration parallele Magnetkonfigurationen sind.

13. Sputteraufbringungsmagnetronsystem nach einem der vorstehenden Ansprüche, wobei das Sputteraufbringungsmagnetronsystem weiter einen Einstellmechanismus zum Anpassen der zumindest einen zusätzlichen Magnetkonfiguration umfasst, wobei der Einstellmechanismus einen beliebigen aus einem Positionierungsmechanismus zum Anpassen der Position der zumindest einen zusätzlichen Magnetkonfiguration oder einem elektrischen oder einem Magnetfeldgenerator zum Anpassen der zumindest einen zusätzlichen Magnetkonfiguration oder einen Parallelschaltungsmechanismus der zumindest einen zusätzlichen Magnetkonfiguration umfasst.

14. Vakuumaufbringungseinrichtung zum Sputtern, wobei die Vakuumaufbringungseinrichtung eine Vakuumkammer, einen Substratträger zum Positionieren eines in der Vakuumkammer zu beschichtenden Substrats und ein Magnetronsputteraufbringungssystem nach einem der Ansprüche 1 bis 13 umfasst.

15. Verwendung eines Magnetronsputteraufbringungssystems nach einem der Ansprüche 1 bis 13 zum Bereitstellen einer Beschichtung auf einer Oberfläche eines Objekts oder zur Plasmabehandlung eines Objekts.

## Revendications

1. Système de magnétron de dépôt par pulvérisation pour pulvériser un matériau, le système de magnétron de dépôt par pulvérisation comprenant
au moins une première et une deuxième unité magnétron de pulvérisation, la première, respectivement la deuxième unité magnétron de pulvérisation comprenant une première, respectivement une deuxième configuration d'aimants (102, 106) et un premier, respectivement un second élément de fixation permettant de fixer une cible (101, 105) de sorte que le champ magnétique de la première, respectivement de la deuxième configuration d'aimants (102, 106) contribue à la formation d'un plasma permettant la pulvérisation de la première, respectivement de la deuxième cible (101, 105),
dans lequel le système de magnétron de dépôt par pulvérisation comprend en outre au moins une configuration d'aimants supplémentaire (103) à distance de l'élément de fixation pour des cibles, dans lequel
la première, la deuxième et l'au moins une configuration d'aimants supplémentaire sont agencées de manière à contribuer chacune à une configuration de plasma confiné, **caractérisé en ce que**, en service, au moins une partie des trajectoires du plasma et des électrons en boucle fermée sont partagées entre la première et la deuxième unité magnétron de pulvérisation, et
la distance la plus courte entre les surfaces cibles de différentes cibles lorsqu'elles sont prises en charge par les unités de pulvérisation magnétron est inférieure à 100 mm.

2. Magnétron de dépôt par pulvérisation selon la revendication 1, dans lequel le premier, le deuxième et au moins un aimant supplémentaire sont positionnés de manière, en service, à forcer la trajectoire d'au moins une partie des électrons participant au processus de dépôt de telle sorte que ces électrons sont accélérés en direction de la surface des deux magnétrons.

3. Système de magnétron de dépôt par pulvérisation selon l'une quelconque des revendications précédentes, dans lequel la première et/ou la deuxième configuration d'aimants est un élément simple formant aimant ou un réseau d'aimants simple.

4. Système de magnétron de dépôt par pulvérisation selon l'une quelconque des revendications 1 à 2, dans lequel la première et/ou la deuxième configuration d'aimants est un élément double formant aimant ou un réseau d'aimants double.

5. Système de magnétron de dépôt par pulvérisation selon l'une quelconque des revendications précédentes, dans lequel la première, la deuxième et l'au moins une configuration d'aimants supplémentaire sont agencées de telle sorte que la configuration d'aimants supplémentaire possède un axe selon l'orientation nord-sud d'au moins un réseau d'aimants de celle-ci formant un angle d'au moins 45° avec l'axe selon l'orientation nord-sud d'au moins un réseau d'aimants des première et deuxième configurations d'aimants.

6. Système de magnétron de dépôt par pulvérisation selon la revendication 5, dans lequel la première, la deuxième et l'au moins une configuration d'aimants supplémentaire sont positionnées de telle sorte qu'au moins une partie des lignes de champ magnétique dans le système se ferment en passant sur la première, la deuxième et l'au moins une configuration d'aimants supplémentaire.

7. Système de magnétron de dépôt par pulvérisation selon la revendication 6, dans lequel les configurations d'aimants des au moins deux unités de pulvérisation magnétron sont agencées de façon qu'au moins 10 % des lignes de champ magnétique de réseaux individuels à l'intérieur des unités de pulvérisation magnétron sont partagées entre différentes configurations d'aimants.

8. Système de dépôt par pulvérisation magnétron selon l'une quelconque des revendications précédentes, dans lequel les configurations d'aimants des première et deuxième unités de pulvérisation magnétron présentent des configurations de polarité d'aimant opposée.

9. Système de magnétron de dépôt par pulvérisation selon l'une quelconque des revendications précédentes, dans lequel la première, la deuxième et l'au moins une configuration d'aimants supplémentaire sont positionnées de manière à fournir un seul plasma dense entre les différentes unités magnétron de pulvérisation.

10. Système de magnétron de dépôt par pulvérisation selon l'une quelconque des revendications 1 à 4, dans lequel les première et deuxième unités de pulvérisation magnétron sont des unités magnétron allongées positionnées de telle sorte que leurs parties d'extrémité sont situées à proximité l'une de l'autre, dans lequel la première et la deuxième configuration d'aimants sont agencées de manière à confiner un plasma à proximité de la première et de la deuxième unité magnétron de pulvérisation, respectivement, et dans lequel l'au moins une configuration d'aimants supplémentaire comprend une configuration d'aimants positionnée à proximité de chaque côté des unités magnétron allongées pour transporter des électrons entre les différentes unités de pulvérisation magnétron.

11. Système de magnétron de dépôt par pulvérisation selon la revendication 10, dans lequel la première, la deuxième et l'au moins une configuration d'aimants supplémentaire sont agencées de telle sorte que la configuration d'aimants supplémentaire présente un axe selon l'orientation nord-sud d'au moins un réseau d'aimants de celle-ci formant un angle inférieur à 45° avec l'axe selon l'orientation nord-sud d'au moins un réseau d'aimants des première et deuxième configurations d'aimants.

12. Système de magnétron de dépôt par pulvérisation selon l'une quelconque des revendications 10 à 11, dans lequel la première et la deuxième configuration d'aimants sont des configurations d'aimants parallèles.

13. Système de magnétron de dépôt par pulvérisation selon l'une quelconque des revendications précédentes, le système de magnétron de dépôt par pulvérisation comprenant en outre un mécanisme d'accord permettant de régler l'au moins une configuration d'aimants supplémentaire, dans lequel le mécanisme d'accord comprend l'un quelconque parmi un mécanisme de positionnement permettant de régler la position de l'au moins une configuration d'aimants supplémentaire ou un générateur de champ électrique ou magnétique permettant de régler l'au moins une configuration d'aimants supplémentaire ou un mécanisme de dérivation de l'au moins une configuration d'aimants supplémentaire.

14. Appareil de dépôt sous vide pour pulvérisation, l'appareil de dépôt sous vide comprenant une chambre à vide, un porte-substrat permettant de positionner un substrat destiné à être revêtu dans la chambre à vide et un système de dépôt par pulvérisation magnétron selon l'une quelconque des revendications 1 à 13.

15. Utilisation d'un système de dépôt par pulvérisation magnétron selon l'une quelconque des revendications 1 à 13 pour fournir un revêtement sur une surface d'un objet ou pour le traitement plasma d'un objet.
